# EUROPEAN PATENT APPLICATION

(11) **EP 0 890 660 A1**
(43) Date of publication of application: **13.01.1999**
(21) Application number: 98112582.6
(22) Date of filing: 07.07.1998
(51) Int. Cl.: C23F 1/18, H05K 3/38

(54) **Microetching agent for copper or copper alloys**

(30) Priority: 08.07.1997 JP 196349/97
(71) Applicant: MEC CO., Ltd., Amagasaki-shi, Hyogo-ken (JP)
(72) Inventor: Yamada, Yasushi, Amagasaki-shi, Hyogo-ken (JP); Haruta, Takahashi, Amagasaki-shi, Hyogo-ken (JP)
(74) Representative: Wächtershäuser, Günter, Prof. Dr.

(57) **Abstract**

A microetching agent for copper or copper alloy comprising an aqueous solution of 1-50% by weight of sulfuric acid, 0.1-20% by weight of hydrogen peroxide, and 0.0001 -3% by weight of at least one of tetrazole or tetrazole derivatives. The composition can roughen surfaces of copper or copper alloys into those possessing deep irregularities that exhibit excellent adhesion to resins such as resists, and superior solderability.

## Description

### BACKGROUND OF THE INVENTION

### Field of the Invention

The present invention relates to a microetching agent for copper or copper alloys, which is useful in applications such as manufacturing of printed circuit boards.

### Description of the Background Art

In the manufacture of printed circuit boards, a common practice is to polish copper surfaces prior to coating them with an etching resist or a solder resist to improve adhesion of these resists to the copper surfaces.

As a means for providing the polishing effect, a mechanical process using a buffing or scrubbing machine or a chemical process known as microetching is used. For treatment of substrates with fine line patterns, microetching is generally adopted.

The microetching treatment is also provided prior to a solder leveler process or prior to mounting electronic components on a circuit board so that the oxide films are removed from the copper surface for better solderability.

In a microetching process, the copper surface is generally etched to a depth of 1-5 µm, determined as a mean thickness calculated from the weight of copper removed, surface area, and the density of the copper.

Meanwhile, as the circuitry patterns formed on printed circuit boards become denser and more intricate, the type of solder resist is being switched from the conventional thermosetting type to an ultraviolet curable type that is superior in producing fine line patterns. However, the ultraviolet curable solder resist tends to lack adhesion to copper surfaces, providing only inadequate adhesion to surfaces produced by a conventional microetching process. This could lead to peeling or blistering failures at the resist coating in subsequent steps such as gold plating, solder leveler, and electronic component mounting.

Furthermore, as a consequence of the trend toward high-density circuitry making, an increasing number of pads for surface mount devices are required on printed circuit boards. This makes solderability of copper surfaces prepared by a conventional microetching process inadequate, which could lead to soldering failures.

Accordingly, an object of the present invention is to provide a microetching agent which can roughen copper surfaces to impart deep, biting ruggedness providing excellent adhesion to materials such as solder resists in addition to superior solderability.

### SUMMARY OF THE INVENTION

The above object can be achieved in the present invention by a microetching agent for copper or copper alloys comprising an aqueous solution of 1-50% of sulfuric acid (all percentage figures hereinafter referred to are % by weight, unless otherwise specified), 0.1-20% of hydrogen peroxide, and 0.0001-3% of at least one compound selected from the group consisting of tetrazole and tetrazole derivatives.

The above object can further be achieved in the present invention by a method of roughening a surface of copper or copper alloy to impart deep, biting ruggedness of a depth of 1 to 5 µm comprising treating said surface with said aqueous solution.

In a preferred embodiment of the present invention, the above tetrazole derivative is selected from the group consisting of 1-methyltetrazole, 2-methyltetrazole, 5-aminotetrazole, 5-amino-1-methyltetrazole, 1-phenyltetrazole, and 5-phenyltetrazole.

Other objects, features and advantages of the invention will hereinafter become more readily apparent from the following description.

### BRIEF DESCRIPTION OF THE DRAWINGS

Figure 1 is an electron microscopic picture at approximately 3,500 magnifications of a roughened surface prepared in Example 1 with the microetching agent of the present invention.
Figure 2 is an electron microscopic picture at approximately 3,500 magnifications of a roughened surface prepared with a conventional microetching agent in Comparative Example 1.

### DETAILED DESCRIPTION OF THE INVENTION AND PREFERRED EMBODIMENTS

The sulfuric acid concentration in the microetching agent according to the present invention is 1-50%, preferably 3-15%, and particularly preferably 5-10%. If said concentration is less than 1%, adequate etching speed cannot be obtained; if higher than 50%, not only is any additional effect unavailable from the extra concentration, but this gives rise to precipitation of copper sulfate.

The hydrogen peroxide concentration applicable in the present invention is 0.1-20%, preferably 1-8%, and particularly preferably 2-4%. If said concentration is less than 0.1%, an insufficient quantity of copper will be dissolved; if higher than 20%, there is no additional effect from the extra concentration.

Additionally, the microetching agent in the present invention is compounded with at least one of tetrazole or tetrazole derivatives in the ratio of 0.0001-3%, preferably 0.001-1%, and particularly preferably 0.01-0.1%. If said concentration is less than 0.0001%, the effect of producing deep and biting irregularities on the copper surfaces for improving adhesion to the solder resist or solderability becomes insufficient; if higher than 3%, the extra concentration will not impart any improvement and will slow down the etching speed.

Given as examples of such a tetrazole derivative mentioned above are 1-methyltetrazole, 2-methyltetrazole, 5-methyltetrazole, 1-methyl-5-ethyltetrazole, 5-aminotetrazole, 5-amino-1-methyltetrazole, 1-(β-aminoethyl)tetrazole, 1-phenyltetrazole, 5-phenyltetrazole. These tetrazole derivatives may be in the form of hydrates or, as long as the desired effect of the present invention is exhibited, may contain other substituent groups. Among the aforementioned group of tetrazole and tetrazole derivatives, tetrazole, 1-methyltetrazole, 2-methyltetrazole, 5-aminotetrazole, 5-amino-1-methyltetrazole, 1-phenyltetrazole, and 5-phenyltetrazole are particularly preferred.

Furthermore, the microetching agent in the present invention may be compounded with additives such as hydrogen peroxide stabilizers including, for example, sulfonic acid or methanol, as required.

The microetching agent in the present invention can be easily prepared by dissolving each of the aforementioned ingredients in water, preferably deionized water. Further, there are no specific limitations to the methods by which the microetching agent in the present invention is used including, for example, a process to spray the microetching agent over copper or copper alloy, or a process to immerse copper or copper alloy in the microetching agent. The preferred temperature for the microetching agent at the time of application is between 10 to 40°C.

The microetching agent in the present invention can be widely used for purposes such as chemical polishing of copper. In particular, treatment with the microetching agent in the present invention helps form deep irregularities on the copper surfaces. The microetching agent thus provides for a surface that has excellent solderability, as well as excellent adhesion to resins, such as an inter-layer insulating material for printed circuit boards, prepreg, solder resist, dry film resist, electro-deposited resist, or adhesives. Accordingly, the agent is extremely advantageous in the manufacture of various printed circuit boards including those for pin grid array (PGA) packages or ball grid array (BGA) packages. It is also useful for surface treatment of lead frames.

Other features of the invention will become apparent in the course of the following description of the exemplary embodiments which are given for illustration of the invention and are not intended to be limiting thereof.

### EXAMPLES

### Examples 1-4 and Comparative Examples 1-2

### (Evaluation of adhesiveness to resins)

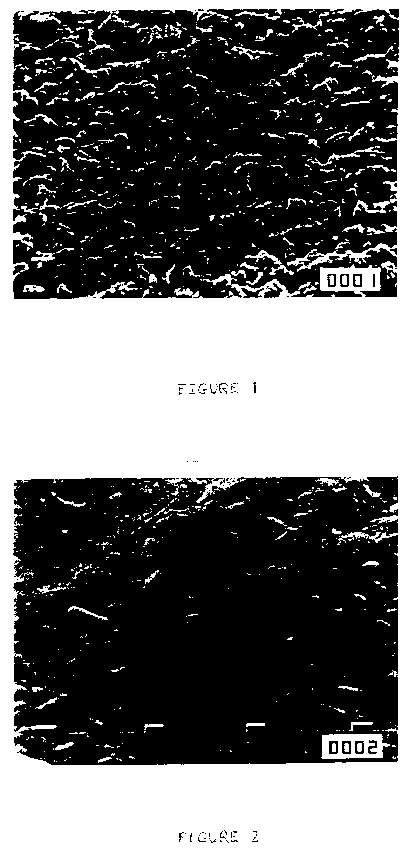

Microetching agents in the present invention (Examples 1 through 4) and microetching agents which do not include tetrazole compounds (Comparative Examples 1 and 2) were prepared by mixing the components listed in Table 1. The microetching agents prepared as above were then sprayed on electroplated copper surfaces of laminates (FR-4) for printed circuit boards, at 30°C, for 10 seconds, to etch the copper layer to a depth of 1.5 µm. The etching depth was determined as a mean thickness calculated from the weight of copper removed, surface area, and the density of the copper. Electron microscopic photographs (approximate magnification: × 3,500) of the resultant surfaces, taken at an angle of 45°, are given in Figure 1 (Example 1) and Figure 2 (Comparative Example 2). Subsequently, said surfaces were coated with a solder resist (PSR-4000 manufactured by Taiyo Ink Manufacturing Co., Ltd.), exposed, developed, and cured.

Next, the cured solder resists prepared in the above were cut into a grid pattern with a 1 mm pitch, in accordance with the provisions of JIS K 5400 Paragraph 8.5.2. The samples were then immersed in 3.5% aqueous hydrochloric acid at room temperature (20°C) for 10 minutes, rinsed with water, and dried. Subsequently, a cross-cut peel-off test using adhesive tape was carried out for the above samples, again in accordance with JIS K 5400 Paragraph 8.5.2. In this test, pieces peeled off and picked up by the adhesive tape were visually inspected and adhesiveness was rated according to the following scale, with results as given in Table 1:
- ⓞ:: No solder resist at all was found on the adhesive tape.
- ○:: A small quantity of solder resist was found on the adhesive tape.
- X:: A large quantity of solder resist was found on the adhesive tape.

### (Evaluation of solderability)

The electroplated copper surfaces of laminates (FR-4) for printed circuit boards were coated with a solder resist (PSR-4000 manufactured by Taiyo Ink Manufacturing Co., Ltd.), which were then exposed so that 560 perforations of 1.5 mm diameter were formed, then developed, and cured for the solderability evaluation. The laminates were sprayed with the microetching agents prepared as described above at 30°C, for 10 seconds, to etch the copper layer to a depth of 1.0 µm (determined as a mean thickness calculated from the weight of copper removed, surface area, and the density of the copper).

Subsequently, the surfaces treated above were coated with a solder leveler flux (W-221, manufactured by MEC Co., Ltd.) and a soldering operation was performed using a vertical type solder leveler at a soldering temperature of 240°C, a dip time of 4 seconds, an air temperature of 220°C, and a squeegee pressure of 3 Kgf/cm². The resultant ratio of soldered perforations to the total was inspected. This is given in Table 1.

**Table 1**

| Example | Compositions (by wt.%) | | Adhesiveness | Solderability (%) |
|---|---|---|---|---|
| 1 | Sulfuric acid | 10 | ⓞ | 100 |
| | Hydrogen peroxide | 6 | | |
| | Amino tetrazole | 0.02 | | |
| | Deionized water | Balance | | |
| 2 | Sulfuric acid | 15 | ⓞ | 100 |
| | Hydrogen peroxide | 8 | | |
| | Methyl tetrazole | 0.05 | | |
| | Sulfonic acid | 0.01 | | |
| | Deionized water | Balance | | |
| 3 | Sulfuric acid | 12 | ⓞ | 100 |
| | Hydrogen peroxide | 6 | | |
| | Phenyl tetrazole | 0.001 | | |
| | Deionized water | Balance | | |
| 4 | Sulfuric acid | 12 | ⓞ | 100 |
| | Hydrogen peroxide | 8 | | |
| | Tetrazole | 0.05 | | |
| | Methanol | 0.01 | | |
| | Deionized water | Balance | | |
| Comparative Example 1 | Sulfuric acid | 12 | X | 84.6 |
| | Hydrogen peroxide | 8 | | |
| | Methanol | 0.5 | | |
| | Deionized water | Balance | | |
| Comparative Example 2 | Sulfuric acid | 15 | X | 82.1 |
| | Hydrogen peroxide | 8 | | |
| | Ethanol amine | 0.05 | | |
| | Sulfonic acid | 0.05 | | |
| | Deionized water | Balance | | |

Treatment with the microetching agent in the present invention enables the formation of a surface that has excellent solderability, as well as excellent adhesion to resins such as an insulating resin, prepreg, resists, or the like. In addition, since the resultant surfaces have less luster than those created by conventional microetching methods, it works also to improve resolution when applied as a first coating beneath a photosensitive resin, or to reduce equipment malfunctions in the inspection process for printed circuit boards using an Automatic Optical Inspector (AOI). Accordingly, the microetching agent in the present invention is suitable for the manufacture of various printed circuit boards that are being constructed with increasingly finer and denser patterns.

Obviously, numerous modifications and variations of the present invention are possible in light of the above teachings. It is therefore to be understood that, within the scope of the appended claims, the invention may be practiced otherwise than as specifically described herein.

## Claims

1. A microetching agent for copper or copper alloy comprising an aqueous solution of 1-50% by weight of sulfuric acid, 0.1-20% by weight of hydrogen peroxide, and 0.0001-3% by weight of at least one compound selected from the group consisting of tetrazole and tetrazole derivatives.

2. The microetching agent according to claim 1, wherein said tetrazole derivative is selected from the group consisting of tetrazole, 1-methyltetrazole, 2-methyltetrazole, 5-aminotetrazole, 5-amino-1-methyltetrazole, 1-phenyltetrazole, and 5-phenyltetrazole.

3. A method of roughening a surface of copper or copper alloy to impart deep, biting ruggedness of a depth of 1 to 5 µm comprising treating said surface with an aqueous solution of 1-50% by weight of sulfuric acid, 0.1-20% by weight of hydrogen peroxide, and 0.0001-3% by weight of at least one compound selected from the group consisting of tetrazole and tetrazole derivatives.

4. The method according to claim 3, wherein said tetrazole derivative is selected from the group consisting of tetrazole, 1-methyltetrazole, 2-methyltetrazole, 5-aminotetrazole, 5-amino-1-methyltetrazole, 1-phenyltetrazole, and 5-phenyltetrazole.
